# EUROPEAN PATENT APPLICATION

(11) **EP 2 452 814 A1**
(43) Date of publication of application: **16.05.2012**
(21) Application number: 12153829.2
(22) Date of filing: 24.04.2007
(51) Int. Cl.: B32B 3/10, B44C 1/22, C30B 33/00

(54) **Porous processing carrier for flexible substrates**

(30) Priority: 28.04.2006 US 413678
(62) Divisional of application: 07755954.0
(71) Applicant: Corning Incorporated, Corning, New York 14831 (US)
(72) Inventor: BOCKO, Peter, L., Painted Post New York 14870 (US); GARNER, Sean, M., Elmira New York 14905 (US); GILLBERG, Gunilla, E., Los Gatos California 95032 (US); LAPP, Josef, C., Corning New York 14830 (US)
(74) Representative: Zijlstra, Robert Wiebo Johan

(57) **Abstract**

The present invention is directed to a substrate product for use in the manufacture of active matrix liquid crystal display panels, flexible displays, or flexible electronics. The product includes a display substrate suitable for use as a display panel. The display substrate has a thickness less than or equal to 0.4 mm. The product also includes at least one porous support substrate removably attached to the display substrate by an adhesive layer.

## Description

This is a continuation-in-part of U.S. Patent Application Serial No. 10/613972 filed on July 3, 2003, the content of which is relied upon and incorporated herein by reference in its entirety, and the benefit of priority under 35 U.S.C. § 120 is hereby claimed.

### BACKGROUND OF THE INVENTION

### FIELD OF THE INVENTION

The present invention relates generally to glass substrates suitable for use in flexible electronic devices, and is particularly beneficial to a glass substrate product for use in AMLCD, OLED, and flexible display manufacturing processes.

### TECHNICAL BACKGROUND

Liquid crystal displays (LCDs) are non-emissive displays that use external light sources. An LCD is a device that may be configured to modulate an incident polarized light beam emitted from the external source. LC material within the LCD modulates light by optically rotating the incident polarized light. The degree of rotation corresponds to the mechanical orientation of individual LC molecules within the LC material. The mechanical orientation of the LC material is readily controlled by the application of an external electric field. This phenomenon is readily understood by considering a typical twisted nematic (TN) liquid crystal cell.

A typical TN liquid crystal cell includes two substrates and a layer of liquid crystal material disposed therebetween. Polarization films, oriented 90° one to the other, are disposed on the outer surfaces of the substrates. When the incident polarized light passes through the polarization film, it becomes linearly polarized in a first direction (e.g., horizontal, or vertical). With no electric field applied, the LC molecules form a 90° spiral. When incident linearly polarized light traverses the liquid crystal cell it is rotated 90° by the liquid crystal material and is polarized in a second direction (e.g., vertical, or horizontal). Because the polarization of the light was rotated by the spiral to match the polarization of the second film, the second polarization film allows the light to pass through. When an electric field is applied across the liquid crystal layer, the alignment of the LC molecules is disrupted and incident polarized light is not rotated. Accordingly, the light is blocked by the second polarization film. The above described liquid crystal cell functions as a light valve. The valve is controlled by the application of an electric field. Those of ordinary skill in the art will also understand that, depending on the nature of the applied electric field, the LC cell may also be operated as a variable light attenuator.

An Active Matrix LCD (AMLCD) typically includes several million of the aforementioned LC cells in a matrix. Referring back to the construction of an AMLCD, one of the substrates includes a color filter plate and the opposing substrate is known as the active plate. The active plate includes the active thin film transistors (TFTs) that are used to control the application of the electric field for each cell or subpixel. The thin-film transistors are manufactured using typical semiconductor type processes such as sputtering, CVD, photolithography, and etching. The color filter plate includes a series of red, blue, and green organic dyes disposed thereon corresponding precisely with the subpixel electrode area of the opposing active plate. Thus, each sub-pixel on the color plate is aligned with a transistor controlled electrode disposed on the active plate, since each sub-pixel must be individually controllable. One way of addressing and controlling each sub pixel is by disposing a thin film transistor at each sub pixel.

The properties of the aforementioned substrate glass are extremely important. The physical dimensions of the glass substrates used in the production of AMLCD devices must be tightly controlled. The fusion process, described in U.S. Pat. Nos. 3,338,696 (Dockerty) and 3,682,609 (Dockerty), is one of the few processes capable of delivering substrate glass without requiring costly post substrate forming finishing operations, such as lapping, grinding, and polishing. Further, because the active plate is manufactured using the aforementioned semiconductor type processes, the substrate must be both thermally and chemically stable. Thermal stability, also known as thermal compaction or shrinkage, is dependent upon both the inherent viscous nature of a particular glass composition (as indicated by its strain point) and the thermal history of the glass sheet, which is a function of the manufacturing process. Chemical stability implies a resistance to the various etchant solutions used in the TFT manufacturing process.

Currently, there is a demand for larger and larger display sizes. This demand, and the benefits derived from economies of scale, are driving AMLCD manufacturers to process larger sized substrates. However, this raises several issues. First, the increased weight of the larger display is problematic. While consumers want larger displays, there is also a demand for lighter and thinner displays. Unfortunately, if the thickness of the glass is decreased, the elastic sag of the glass substrate becomes a problem. The sag is further exacerbated when the size of the substrate is increased to make larger displays. Presently, it is difficult for TFT manufacturing technology to accommodate fusion glass thinner that 0.5mm because of glass sag. Thinner, larger substrates have a negative impact on the processing robotics' ability to load, retrieve, and space the glass in the cassettes used to transport the glass between processing stations. Thin glass can, under certain conditions, be more susceptible to damage, lending to increased breakage during processing.

In one approach that has been considered, a thick display glass substrate is employed during TFT processing. After the active layer is disposed on the glass substrate, the opposite face of the glass substrate is thinned by grinding and/or polishing. One drawback to this approach is that it requires an additional grinding/polishing step. The expense of the additional step(s) is thought to be quite high.

Therefore, it would be highly desirable to provide an ultra-thin, flexible substrate that would allow for the direct formation of thin film transistors without having to subject the display substrate to an additional polishing and/or grinding step. Current glass substrate thicknesses, for example, are on the order of 0.6 - 0.7mm. By decreasing the thickness of the substrate to 0.3mm, a 50% reduction in weight will be achieved. However, ultra-thin glass has an unacceptably high degree of sag and can be prone to breakage. What is needed is an ultra-thin substrate product that may be employed in the state-of-the art TFT manufacturing processes without the aforementioned problems.

### SUMMARY OF THE INVENTION

In one embodiment according to the present invention, a substrate product for use in the manufacture of an electronic device is provided comprising a porous support substrate an adhesive layer disposed on the support substrate a display substrate suitable for use as a display panel disposed on the adhesive layer, the display substrate having a thickness less than or equal to 0.4 mm and wherein the adhesive layer is removable by a method which does not damage the display substrate

In another embodiment, a method for making a flexible display panel is provided, the method comprising forming at least one flexible display substrate suitable for use as a display panel, attaching a porous support substrate to the at least one display substrate with an adhesive, the adhesive in contact with both the display substrate and the support substrate, forming a display device on the at least one display substrate and removing the support substrate attached to the at least one display substrate.

In still another embodiment, a method for making a display panel is disclosed, the method comprising forming at least one glass display substrate suitable for use as a display panel, the at least one glass display substrate having a thickness less than or equal to 0.4 mm, attaching a porous support substrate to the at least one display substrate, forming a display device on the at least one display substrate, encapsulating the device on the at least one display substrate and removing the support substrate attached to the at least one display substrate by applying a positive pressure to the display substrate through the porous support substrate.

Additional features and advantages of the invention will be set forth in the detailed description which follows, and in part will be readily apparent to those skilled in the art from that description or recognized by practicing the invention as described herein, including the detailed description which follows, the claims, as well as the appended drawings.

It is to be understood that both the foregoing general description and the following detailed description are merely exemplary of the invention, and are intended to provide an overview or framework for understanding the nature and character of the invention as it is claimed. The accompanying drawings are included to provide a further understanding of the invention, and are incorporated in and constitute a part of this specification. The drawings illustrate various embodiments of the invention, and together with the description serve to explain the principles and operation of the invention.

### BRIEF DESCRIPTION OF THE DRAWINGS

Figure 1 is a diagrammatic depiction of the substrate product of the present invention in accordance with a first embodiment of the present invention;

Figure 2 is a diagrammatic depiction of the substrate product of the present invention in accordance with a second embodiment of the present invention;

Figure 3 is a diagrammatic depiction of the substrate product of the present invention in accordance with a third embodiment of the present invention;

Figure 4 is a diagrammatic depiction of the substrate product of the present invention in accordance with a fourth embodiment of the present invention;

Figure 5 is a diagrammatic depiction of an alternate embodiment of the substrate product depicted in Figure 1;

Figure 6 is a detail view showing the disposition of a TFT transistor on the display substrate depicted in Figure 1; and

Figure 7A-7B are detail views illustrating TFT processing in accordance with the present invention.

Figure 8 is a cross sectional view of a portion of a substrate product according to an embodiment of the present invention illustrating a flexible substrate adhered to a microporous support substrate.

Figure 9 is a cross sectional view of a portion of a substrate product according to an embodiment of the present invention illustrating a flexible substrate adhered to a microporous support substrate with a discontinuous adhesive layer.

### DETAILED DESCRIPTION

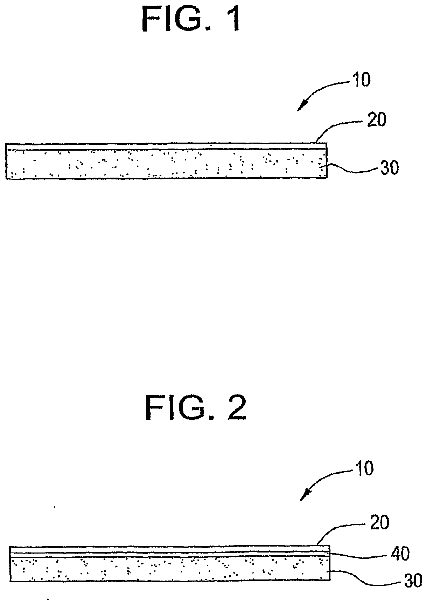

Reference will now be made in detail to the present exemplary embodiments of the invention, examples of which are illustrated in the accompanying drawings. Wherever possible, the same reference numbers will be used throughout the drawings to refer to the same or like parts. An exemplary embodiment of the substrate product of the present invention is shown in Figure 1, and is designated generally throughout by reference numeral 10.

In accordance with the invention, the present invention is directed to a substrate product for use in the manufacture of flexible electronic panels. Flexible electronic panels can encompass such electronic products as radio frequency identification tags (RFIDs), photovoltaics (e.g. solar cells), printable electronics, as well as other flexible products. The substrate product disclosed herein is especially suitable for the manufacture of active matrix liquid crystal displays (AMLCD), organic light emitting diode displays (OLEDs), electrophoretic displays, field emission displays (FEDs), thin film light emitting polymer displays (TFT LEP) and cholesteric liquid crystal displays to name a few. As used hereinafter, and for purposes of illustration only, the substrate on which an electronic device will be formed will be termed the display substrate, with the understanding that this term contemplates the manufacture of flexible substrates for purposes beyond the narrow range of optical displays. Moreover, the display substrate may be formed from other materials other than glass, for example polymer films, stainless steel, and other glass compositions are all contemplated. Again, for purposes of illustration and not limitation, a glass display substrate will be described.

For AMLCD devices in particular, the display substrate has a thickness less than or equal to 0.4mm a composition that is substantially alkali free, and a surface smoothness that allows the direct formation of thin-film transistors thereon without a prior processing step of polishing and/or grinding. The substrate product also includes at least one support substrate removably attached to the display substrate. Accordingly, the present invention provides an ultra-thin glass substrate that can be used in state-of-the art TFT manufacturing processes. While a preferred method of manufacturing the display substrate is a fusion method for the advantages recited supra, the present invention may prove beneficial using display substrates manufactured by other methods. The display substrate preferably has a smoothness that allows the direct formation of thin-film transistors without having to perform a polishing or grinding step.

As embodied herein, and depicted in Figure 1, a diagrammatic depiction of the substrate product **10** of the present invention in accordance with a first embodiment of the present invention is disclosed. Substrate product 10 is a glass-on-glass laminate that has an overall thickness in the range between 0.6 - 0.7mm. Those skilled in the art will understand that this range is compatible with conventional TFT processing techniques. Product **10** includes display substrate **20** and support substrate **30.** Display substrate **20** has a thickness preferably in the range between about 0.1 mm and 0.4 mm. However, the thickness of support substrate **30** depends on the thickness of the display substrate and the overall thickness of product **10.**

Display substrate **20** may be of any substrate type suitable for use in a display panel (e.g. an LCD display panel), as long as the display substrate has a thickness less than or equal to about 0.4 mm. If glass, the substrate composition is preferably substantially alkali free, and has a surface smoothness that allows the direct formation of thin-film transistors thereon without a prior processing step of polishing and/or grinding. Reference is made to U.S. Patent No. 5,374,595 and U.S. Patent No. 6,060,168, which are incorporated herein by reference as though fully set forth in their entirety, for a more detailed description of the composition of the glass comprising display substrate **20.**

It will be apparent to those of ordinary skill in the pertinent art that modifications and variations can be made to support substrate **30** of the present invention depending on the means used to separate support layer **30** from display substrate **20** after TFT processing is completed. For example, support substrate **30** may be comprised of a sacrificial non-display glass composition (lost glass) suitable for chemical dissolution without subsequent damage to the display substrate. In another embodiment, support substrate **30** may be comprised of a relatively soft non-display glass composition removable by grinding/polishing without subsequent damage to the display substrate. Those of ordinary skill in the art will recognize that many varieties of relatively inexpensive glasses may be used in the production of support layer **30.**

A laminate substrate product **10,** having surfaces which are essentially defect-free and equivalent in smoothness to polished surfaces, can be fashioned in accordance with the following steps. First, two alkali metal-free batches of different compositions are melted. The batch for the display glass must exhibit a strain point higher than 600° C, and be relatively insoluble in an acid solution. The batch for the support glass substrate consists, expressed in terms of cation percent on the oxide basis, of

| | | | | | |
|---|---|---|---|---|---|
| SiO₂ | 27-47 | B₂O₃ | 0-40 | SrO and/or BaO | 0-10 |
| Al₂O₃ | 15-43 | MgO | 0-4 | ZnO | 0-7 |
| CaO | 5-25 | | | MgO + SrO + BaO +ZnO | 0-15 |

One current candidate for the support glass substrate, expressed in terms of cation percent on an oxide basis, consists of SiO₂ 41, Al₂O₃ 18, B₂O₃ 32 and CaO 9.

Reference is made to U.S. Patent No. 4,102,664 and U.S. Patent No. 5,342,426, which are incorporated herein by reference as though fully set forth in their entirety, for a more detailed description of a method for making laminated bodies.

The support glass is at least 1000 times more soluble in the same acid solution and exhibits a linear coefficient of thermal expansion from its setting point to room temperature within about 5 x 10⁻⁷ /°C of that of the display glass substrate. The support glass also exhibits a strain point higher than 600°C and relatively close to the strain point of the display glass substrate. The support glass is characterized by a linear coefficient of thermal expansion over the temperature range of 0°C - 300°C between 20-60 x 10⁻⁷/°C.

The molten batches are brought together simultaneously while in the fluid state to form a laminated sheet wherein the display glass is essentially completely enclosed within the support glass. The layers are fused together at a temperature where the melts are in fluid form to provide an interface therebetween which is defect-free. The laminated sheet is cooled to solidify each glass present in fluid form.

As discussed above, after TFT processing is completed, an acid solution is used to dissolve the support glass. The resultant surface of the display glass, from which the support glass has been removed, is rendered essentially defect-free and is equivalent in smoothness to a polished glass surface. The dissolution of the soluble glass (lost glass) in an acid bath will be carried out after the laminated sheet has arrived at its destination. Thus, sheets cut from the laminate can be readily stacked and shipped to the LCD display device manufacturer.

The liquidus temperature values of the two glasses will preferably be below the temperature at which lamination is conducted in order to prevent the occurrence of devitrification during the select forming process.

Finally, in accordance with conventional practice, the laminated sheet may be annealed to avoid any detrimental strains, most preferably during the cooling step, although the cooled laminate may be reheated and thereafter annealed. As has been explained above, the strain points of the present inventive glasses are sufficiently high that annealing may not be required in the formation of a-Si devices.

As embodied herein, and depicted in Figure 2, an alternate embodiment of substrate product **10** of the present invention is disclosed. Again, substrate product **10** has an overall thickness of between 0.6-0.7 mm, which is compatible with current TFT processing techniques. Display substrate **20** has a thickness in the range between 0.1 mm and 0.4 mm. The thickness of support substrate **30** depends on the thickness of the display substrate and the overall thickness of product **10.** However, the support substrate itself may be very flexible, as long as the laminate structure of support substrate and display substrate exhibits a rigidity sufficient to undergo subsequent conventional processing, such as the addition of TFT and related handling. In this embodiment, support substrate **30** is tacked onto display substrate **20** using adhesive **40.** Adhesive **40** is a high temperature flux that is formulated to withstand high temperatures of poly-Si processing, which may approach 450°C. Further, support substrate **30** and adhesive **40** are of a type to withstand the chemical, mechanical, and optical environmental stresses encountered during TFT processing. Reference is made to U.S. Patent 5,281,560 which is incorporated herein by reference as though fully set forth in its entirety, for a more detailed description of possible adhesives.

The composition of display substrate **20** and support substrate **30** were disclosed above in the discussion of the first embodiment. Both display substrate **20** and support substrate **30** may be fabricated using fusion draw processes, or any other suitable substrate manufacturing process capable of meeting the display substrate requirements, e.g. being substantially alkali-free and sufficiently smooth as to allow the deposition of electronic components (e.g. TFTs) without grinding and/or polishing. Reference is made to U.S. Patent No. 3,338,696 and U.S. Patent 3,682,609, which are incorporated herein by reference as though fully set forth in their entirety, for a more detailed explanation of a system and method for producing glass substrates using the fusion draw technique. By using higher gear ratio drives and composite pulling rolls, the fusion draw technique is well able to produce glass substrates having a thickness of approximately 100 microns (0.1 mm). One advantage of using a fusion glass as a support substrate is its superior flatness. The flatness of the surface is important because it minimizes focusing errors during the photolithographic steps performed during TFT processing. Further, the linear coefficient of thermal expansion (CTE) of support substrate **30** can be made to match that of the display glass. If the substrates have dissimilar CTEs, product warping may occur. Another advantage of using the fusion draw process is the ability to make a support substrate having a higher modulus of elasticity.

The above described second embodiment has the same advantages as the first embodiment. Substrate product **10** has overall thickness, weight, and sag characteristics that are compatible with state-of-the art TFT processing. The use of sacrificial support layer **30** enables the fabrication of lighter and thinner display panels.

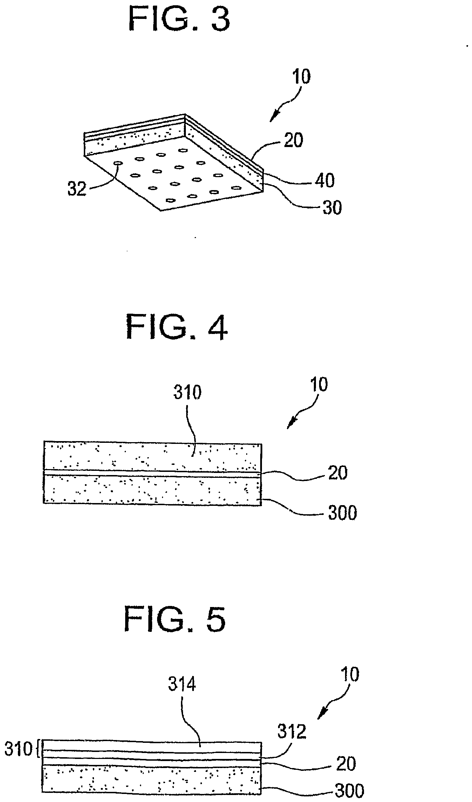

Referring to Figure 3, and Figures 8 and 9, other alternative embodiments of the present invention are disclosed. In these embodiments, support substrate **30** is a porous material. Advantageously, a porous support substrate can provide for reduced debonding stresses, thereby facilitating removal of the display substrate from the support substrate. In accordance with the present embodiment, display substrate **20** is bonded to support substrate **30** via an adhesive layer **40.** Display substrate **20** typically has a thickness less than about 400 microns (μm) and more preferably within the range of about 1 μm to 400 μm. Adhesive layer **40** may include, for example, a thermally cured adhesive, an etchable high temperature flux, a UV-curable adhesive or a solventdissolvable adhesive. Release of display substrate **20** can be performed according to the type of adhesive used. For example, if a thermal adhesive is employed, the laminated sandwich of support substrate, adhesive and display substrate may be heated to reduce the bonding strength of the adhesive. If a UV adhesive is used, the laminate may be exposed to UV radiation to weaken the bonding strength, while dissolvable adhesives may be removed or weakened by exposing the adhesive to a suitable solvent or etchant.

The use of a dissolvable adhesive is particularly advantageous when used in combination with a porous support substrate, as the porosity of the support substrate facilitates migration of the solvent or etchant through the open pores of the support substrate to the adhesive. Thus, the adhesive is attacked by the solvent or etchant over an increased surface area of adhesive **40** than would occur if the adhesive was in contact with the solvent only at the edges of product **10.** The use of a non-porous support substrate and a dissolvable (or otherwise decomposable) adhesive limits the effectiveness of the solvent by confining the area of the adhesive exposed to the solvent to the adhesive at the edges of product **10,** and dissolution of the adhesive by the solvent or etchant progresses inward from the edges at an unacceptably slow rate.

A wide variety of adhesives can be used to secure display substrate **20** to support substrate **30,** depending on the material and process compatibility required. These may include organic adhesives, siloxanes, composites, and inorganic bonding materials such as glass frits. Also, a temporary bond may be produced between the display substrate and the support substrate directly. Because of this, other release mechanisms are also possible. For example, an acid or base solution can be used to decrease the adhesive bond strength or directly etch away the adhesive interface. Likewise, heated gas or other vapor can be delivered through the porous support substrate when substrate de-lamination is required. In this case the release mechanism could be a thermal process or a solvent/etch process. Heated gas could be used to heat the adhesive and cause the display substrate to be released without substantially increasing the display substrate temperature. Likewise, irradiating the adhesive with light having a suitable wavelength or range of wavelengths, dependent upon the adhesive used, may employed to break down the adhesive. For example, infrared (IR) or ultraviolet (UV) light may be used.

Different scenarios are possible for the placement of adhesive **40** between display substrate **20** and porous support substrate **30.** For example, the adhesive can be first applied to the display substrate, after which the display substrate is bonded to the support substrate. Alternatively, the adhesive can be applied to the support substrate first, or to both individually, or to both simultaneously during the lamination process. In another embodiment, the adhesive may be permanently attached to the substrate and temporarily attached to the support substrate. The opposite is also possible. The adhesive can be applied or deposited to form a film on either substrate, or the adhesive can be a preformed film that then gets applied to either substrate.

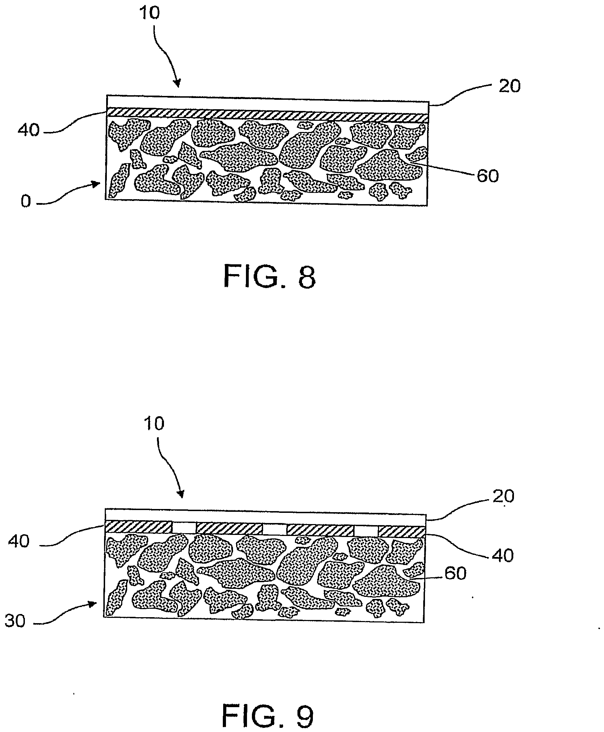

In another embodiment, the adhesive could form a continuous layer between the display substrate and the support substrate, or the adhesive layer itself could be porous as shown in Figure 9. In these cases, adhesive **40** could cover all, some, or none of the support substrate surface porosity. The adhesive porosity could have the same or different porosity than the porous carrier. Figures 8 and 9 illustrate cases where the adhesive layer is continuous or forms a discontinuous (e.g. porous) layer, respectively.

Depending on the material, chemical, process, and other compatibility issues, the porous support substrate could be made out of a wide range of materials. These include organics, inorganics, or composites. For example, glass support substrates are appropriate in cases where high temperature, solvent resistance, and CTE matching to Si is required. As suggested above, the support substrate by itself does not need to be completely rigid as long as the laminated display substrate-support substrate structure has enough stiffness to be handled.

The main purpose of the support substrate porosity is to allow effective interaction of a fluid (either a liquid or a gas) with the adhesion interface. To fulfill this need, the support substrate pore size can range from sub-micron to several millimeters and the porosity can range from <10% to >90%. By pore size what is meant is the average or effective cross-sectional diameter of the pore. Large pore sizes allow large and immediate interaction of external liquid or gas with the adhesion interface. Large pore sizes, however, may result in dimpling of the display substrate as it sags over the pores. On the other hand, small pore sizes reduce the interaction at the adhesion interface but support the display substrate more continuously. At the extreme, a non-porous support substrate offers continuous display substrate support but interaction between the adhesive and the solvent is limited to the edges of product **10.**

As discussed supra, the support substrate could have a wide range of pore sizes and porosity levels to fit the application requirements. For example, on one end of the spectrum, the support substrate could have sub-micron pore characteristics similar to porous Vycor™. By sub-micron pore characteristics what is meant is that an average diameter of the pores is less than about 1 micron. A material with such non-straight, submicron interstitial passages or pores **60** will hereinafter be referred to as microporous (see FIGs 8-9). On the other hand, the pores could actually resemble through channels or holes (macro-porosity) such as are produced by extruded ceramic honeycomb structures used in cellular ceramics (e.g. catalytic converters) for example. Such structures may exhibit both micro-porous and macro-porous characteristics. FIG. 3 illustrates a support substrate having holes **32** drilled through the substrate perpendicular to the surface of the substrate. The size and number of holes depends on the release mechanism used to separate product **10** from the processing station. However, pore size in such macro-porous materials can be controlled at the micron level. Some of these through-holes can be used for passively aligning the support substrate with different processing equipment. The top, bottom, or side surface pores could also be blocked off permanently or temporarily to form patterns as needed.

The porous support substrate as embodied herein provides a distributed support across the entire flexible substrate, but it also reduces the actual contact area. This reduced contact area can be used to control the adhesive force between the flexible display substrate and the support substrate. Substantial contact between the display substrate and the support substrate occurs only in the regions of the support substrate between the surface pores. However, adhesive may also be present within the surface pores. The overall reduction in bond strength then requires either a lower de-lamination force or a lower de-lamination time to separate the display substrate. In either case, the probability for device breakage and manufacturing yield are improved.

As noted previously, a backside positive pressure can also be applied through the porous support substrate. By positive pressure what is meant is a pressure greater than the ambient atmospheric pressure. This provides a distributed force across the display substrate during de-lamination. This force can be applied to the side of the support substrate opposite the side having the adhesive and display substrate, either through a gas or liquid interaction. In contrast, separating the display substrate from a non-porous support substrate requires applying a peeling force from the edge of product 10. This peeling force produces a local stress increase and increases the probability of breaking the display substrate or device fabricated upon it.

In another alternative embodiment, display substrate **20** can be held on support substrate **30** by applying a negative pressure to the display substrate through the porous support substrate. For example, a vacuum can be applied to the backside of support substrate **30** (the side of support substrate **30** opposite the display substrate), thereby causing atmospheric pressure to hold the display substrate against the support substrate.

A temporary film may be applied to the display substrate to prevent damage to the substrate. For example, a suitable plastic film may be used. If an adhesive or other film are not used, the display substrate is in effect bonded directly to the support substrate. In forming a liquid crystal display panel, a display substrate **20** is attached to porous support substrate **30** by adhesive **40.** A liquid crystal device may then be formed on the display substrate. The device is encapsulated, such as by forming a hermetic seal between display substrate **20** and a second substrate, after which the encapsulate device may be removed from the support substrate in accordance with the methods taught herein.

In one method of forming an OLED device, for example, a display substrate **20** is attached to porous support substrate **30** by adhesive **40.** An OLED device may then be formed on the display substrate through the required deposition, photolithography, etch, or other fabrication steps. The device is encapsulated, such as by forming a thin film hermetic layer on top of the OLED device structure, after which the encapsulate device may be removed from the support substrate in accordance with the methods taught herein.

To demonstrate the use of a porous support substrate, the de-lamination performance of a cellular ceramic and a porous Vycor carrier were compared to that of a non-porous microscope slide. The porous Vycor was a 1" x 1" square sample of a standard product manufactured by Coming Incorporated as an example of a small pore size micro-porous support substrate. The cellular ceramic support substrate was a cordierite sample and had an interstitial pore size of ∼ 18 μm and a porosity of 50%. These were disks of 1¼" diameter and 3/8" thickness. Additionally, the ceramic support substrate had large pores (through-holes) of about 2mm square. In the demonstrations, microscope slides (75mm x 50mm x 1.06mm) were used as a reference non-porous carrier. Standard zinc borosilicate microscope slide cover glass (approximately 20mm x 20mm x 0.15mm) was used as an example of a flexible substrate.

In a first demonstration, four support substrates were cleaned with acetone, IPA, and DI water and then thoroughly dried. The four carriers were: a control microscope slide, a second microscope slide, porous Vycor, and a piece of cellular ceramic material as noted above. For each support substrate, a 1mil thick piece of silicone-based double-sided PSA (pressure sensitive adhesive) from Adhesive Research was applied to the surface. After the PSA was adhered, the upper release liner was removed to expose the top adhesive surface. The flexible substrate (cover glass) was then applied to the support substrates, with the exception of the first, control microscope slide. The PSA on the control support substrate was left uncovered to observe the effects of the applied delaminating solvent. All four samples were then placed in a dish containing acetone with the support substrate bottom (un-adhered) surface resting on the dish bottom.

Bubbles were emitted from the porous Vycor and cellular ceramic samples in less than about 1 minute, with the Vycor sample producing bubbles at a slower rate than the cellular ceramic sample (possibly the displacement of air contained in the porous support substrates by the solvent). After about 8 minutes, the PSA on the first, uncovered control microscope slide was observed to have blistering on the surface.

After about 30 minutes, the control sample PSA and that of the cellular ceramic support substrate had severe blistering of the surface. When slightly agitated, the cover slide de-laminated from the cellular ceramic support substrate. In contrast, the porous Vycor and non-porous microscope slide carrier samples had blistering along only the exposed regions of the PSA at the edges of the samples. At this time, an equal amount of IPA was added to the acetone. After an additional 30 minutes, the porous Vycor and microscope slide carrier samples were removed. These were given a DI water rinse followed by drying with an air gun. During the drying process, the cover glass bonded to the porous Vycor became delaminated. In contrast, the cover glass bonded to the non-porous microscope slide carrier was still strongly bonded, and it was required to break the glass to remove it. In this example, no small bend radius peeling motion was required to remove the flexible substrate from either the porous ceramic or Vycor support substrates.

In another demonstration, an organic adhesive was used to bond the cover glass and support substrates, removable with an organic solvent. In this case, cover glasses were bonded to both a porous cellular ceramic support substrate and a non-porous microscope slide carrier using Shipley 5740 photoresist readily dissolved in acetone/IPA solutions. The photoresist was first spun cast onto two cover glass samples at 4,000 RPM for 30 seconds at an acceleration of 2,000 RPM/s. The cover glasses were then placed (coated side up) onto a room temperature hot plate. A porous cellular ceramic and a non-porous microscope slide carriers were then placed on top of the coated flexible substrates. The residual photoresist solvent was driven off by heating the hot plate to 110°C, holding the temperature constant for 5 minutes, and then cooling the plate below 90°C before removing the samples. The cover glass was well bonded to both support substrates. Both support substrates and the bonded cover glasses were then placed into the acetone/IPA solution described above with the unbonded support substrate surface touching the bottom of the dish. In less than about 30 seconds, the cover glass bonded to the porous cellular ceramic support substrate floated off, and the remaining photoresist completely dissolved. After about 30 minutes, the non-porous microscope slide carrier with attached cover glass was removed from the solvent and given a DI water rinse and air gun dry. The cover glass was still strongly bonded to the microscope slide with no indication that the adhering photoresist was affected by the solvent. It was required to break the cover glass to remove it from the microscope slide.

In still another embodiment, the release mechanism employs lifting pins made from a soft non-abrasive material such as Teflon. In another embodiment, the release mechanism applies gas or liquid to lift the substrate. The physical configuration of support substrate **30** may also include corrugation or "egg crate" designs. Support substrate **30** may also be comprised of recyclable glass. After processing, substrate **30** may be ground into cullet and reformed using one of the above described fabrication techniques. Substrate **30** may also be re-used without being ground into cullet.

In another embodiment, support substrate **30** includes a lip that surrounds display substrate **20.** In this embodiment, a vacuum may be applied to the display substrate **20** via holes **32** to keep product **10** in place during processing. In this embodiment, adhesive **40** may not be necessary. However, if no adhesive is applied, a diamond like coating (DLC) is applied to the surface of support substrate **30** on which display substrate **20** rests. The DLC aids in the distribution of heat, is scratch resistant, and allows the display substrate **20** to be easily released after processing. In this embodiment, a gas or liquid may be applied to release display substrate **20.**

As embodied herein, and depicted in Figure 4, yet another embodiment of the present invention is disclosed. Substrate **10** includes display substrate **20** coated on both sides with lost glass substrates **300** and **310.** This embodiment provides additional protection to display substrate **20.** Prior to TFT processing and disposition, one of the support layers is removed. After TFT processing, the second layer is removed and the plastic polarization film is applied to the backside of display substrate **20.** As described above, the properties of the lost glass would have to be compatible with TFT processing conditions.

Referring to Figure 5, yet another alternate embodiment of substrate product **10** is disclosed. This embodiment is similar to the embodiment shown in Figure 1, in that substrate product **10** is a laminate that includes display substrate **20** and support substrate **300.** However, product **10** may be shipped to a display manufacturer, for example an LCD manufacturer, having a pre-processing layer **310** disposed thereon. Layer **310** includes a silica layer **312** disposed on display substrate **20.** A silicon layer **314** is disposed on silica layer **312.** Both layers may be formed using chemical vapor deposition (CVD) techniques. The advantage of this embodiment will be apparent after the following discussion.

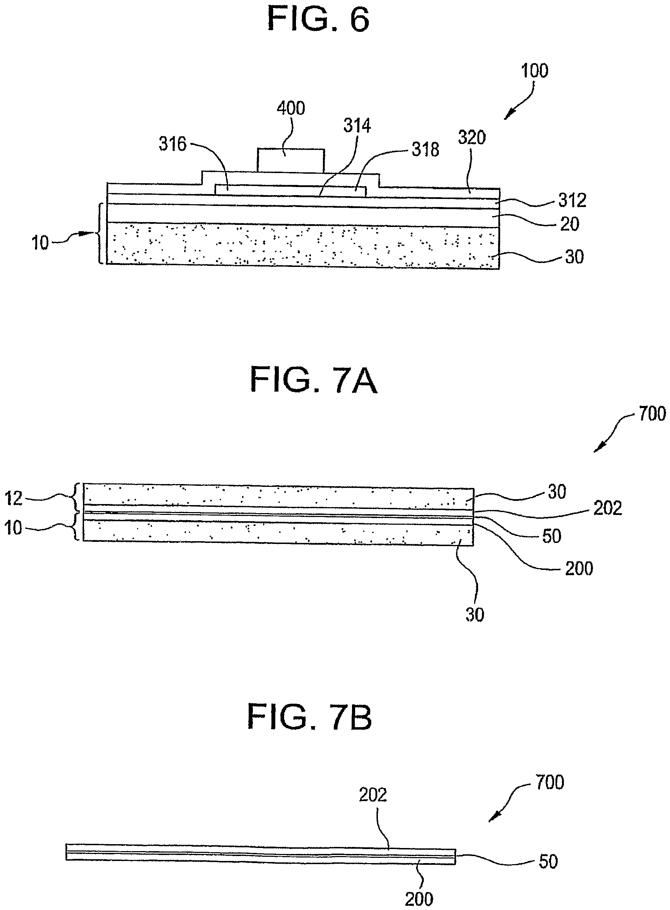

Referring to Figure 6, a cross-sectional view of a TFT on an active substrate is shown. Active substrate **100** of the present invention includes display substrate **20** disposed on support substrate **30.** Using the reference number convention employed in Figure 5, insulating silica layer **312** is disposed on display substrate **20.** Active layer **314,** formed from a semiconductor (Si) film, is disposed on insulating layer **312.** A gate insulation layer is disposed on active layer **314.** Gate **400** is disposed on gate insulator **320** over the center of the active area. Source **316** and drain **318** are formed in the active area. During operation, current flows from the source **316** to the drain **318** when power is applied to the transistor. Pixel actuation is controlled by a circuit coupled to drain **318.** The configuration of the TFT transistor **100** shown in Figure 6 is for illustration purposes, and the present invention should not be construed as being limited to a transistor of this type. Accordingly, Figure 6 illustrates the use of a sacrificial support layer **30** to enable the fabrication of TFTs on lighter and thinner display substrates having a thickness between 0.1 - 0.4 mm. Those skilled in the art will understand that substrate product **10** has an overall thickness, weight, and sag characteristics that are compatible with conventional TFT processing. Thus, the present invention may be employed without any significant alteration to TFT manufacturing processes. Once TFT processing is complete, the sacrificial layer may be removed using one of the above described techniques.

Figure 7A and Figure 7B are detail views illustrating a method for making an active matrix liquid crystal display panel in accordance with the present invention. As shown in Figure 7A, an active matrix liquid crystal display panel is produced using substrate product **10** and substrate product **12,** both fabricated in accordance with the principles of the present invention. A plurality of thin film transistors are disposed on display substrate **200** of substrate product **10** to produce an active substrate. A color filter is disposed on display substrate **202** on product **12** to produce a color filter substrate. Subsequently, liquid crystal material **50** is placed between active substrate **200** and color filter substrate **202,** and sealed with an appropriate material. As shown in Figure 7B, the support substrates **30** attached to each of the display substrates **(200, 202)** are removed. To illustrate the advantages of the present invention, it is noted that if display substrate **200** and display **202** each have a thickness of 0.3 mm, the resultant display panel **700** will be 50% lighter than conventional AMLCD panels, since the thicknesses of conventional display substrates are on the order of 0.6 - 0.7 mm. If display substrate **200** and display substrate **202** each have a thickness of 0.1 mm, the resultant display panel **700** will be approximately 80% lighter than conventional AMLCD panels.

It will be apparent to those skilled in the art that various modifications and variations can be made to the present invention without departing from the spirit and scope of the invention. Thus, it is intended that the present invention cover the modifications and variations of this invention provided they come within the scope of the appended claims and their equivalents.

## Claims

1. A substrate product comprising:
a glass display substrate suitable for use as a display panel, the glass display substrate having a thickness less than or equal to 0.4 mm, a composition that is substantially alkali free, and a surface smoothness that allows the direct formation of thin-film transistors thereon without a prior processing step of polishing and/or grinding; and
at least one glass support substrate removably attached to the display substrate with an adhesive.

2. The substrate product according to claim 1, wherein the at least one glass support substrate comprises a plurality of holes extending therethrough.

3. The substrate product according to claim 1, wherein the at least one glass support substrate comprises a lip that surrounds the glass display substrate.

4. The substrate product according to claim 1, wherein the at least one glass support substrate includes a first glass support substrate disposed on a first side of the glass display substrate and a second glass support substrate disposed on a second side of the glass display substrate.

5. The substrate product according to claim 1, wherein a strain point of the glass display substrate is greater than 600°C.

6. The substrate product according to claim 1, wherein a strain point of the at least one glass support substrate is greater than 600°C.

7. The substrate product according to claim 1, wherein the glass display substrate comprises a silicon layer disposed thereon.

8. The substrate product according to claim 1, wherein the glass display substrate comprises a thin film transistor disposed thereon.

9. The substrate product according to claim 1, wherein the at least one glass support substrate comprises a corrugated surface.

10. The substrate product according to claim 1, wherein the thickness of the glass display substrate is in a range from 0.1 mm to 0.4 mm.

11. The substrate product according to claim 1, wherein a coefficient of thermal expansion of the glass display

12. A method for making a substrate product comprising:
forming a first glass display substrate suitable for use as a display panel, the first glass display substrate having a thickness less than or equal to 0.4 mm, a composition that is substantially alkali free, and a surface smoothness that allows the direct formation of thin-film transistors thereon without a prior processing step of polishing and/or grinding; and
attaching at least one glass support substrate to the first glass display substrate with an adhesive.

13. The method according to claim 10, further comprising forming a plurality of thin film transistors on the glass display substrate.

14. The method according to claim 11, further comprising attaching a second glass display substrate to the first glass display substrate.

15. The method according to claim 11 or claim 12, further comprising removing the glass support substrate attached to the first glass display substrate.
